# EUROPÄISCHE PATENTANMELDUNG

(11) **EP 1 083 434 A2**
(43) Veröffentlichungstag der Anmeldung: **14.03.2001**
(21) Anmeldenummer: 00118531.3
(22) Anmeldetag: 25.08.2000
(51) Int. Cl.: G01R 31/28, G01R 1/073

(54) **Vorrichtung zum Prüfen von Leiterplatten**

(30) Priorität: 10.09.1999 DE 19943388
(71) Anmelder: ATG TEST SYSTEMS GmbH & Co. KG, 97877 Wertheim (DE)
(72) Erfinder: Weiss, Stefan, 97887 Wertheim (DE)
(74) Vertreter: Ganahl, Bernhard

(57) **Zusammenfassung**

Die Erfindung betrifft eine Vorrichtung zum Prüfen von Leiterplatten, mit einer Auswerteelektronik, einem Grundraster, das in einem regelmäßigen Raster in einer Grundrasterebene angeordnete Kontaktpunkte aufweist, die elektrisch mit der Auswerteelektronik verbunden sind, so daß Leiterplattentestpunkte einer zu prüfenden Leiterplatte, die mittels eines Adapters und/oder eines Translators mit den Kontaktpunkten des Grundrasters in Verbindung bringbar sind, elektrisch abgetastet werden können, wobei mehrere Kontaktpunkte des Grundrasters elektrisch miteinander verbunden sind.

Die Erfindung zeichnet sich dadurch aus, daß die Vorrichtung mehrere Grundrasterleiterplatten aufweist, die jeweils eine Kontaktpunktschmalseitenfläche besitzen, an der die Kontaktpunkte angeordnet sind, und mit Leiterbahnen versehen sind, die jeweils mit mehreren Kontaktpunkten elektrisch verbunden sind und eine zu einem Anschlußkontakt zum Anschließen der Auswerteelektronik führende elektrische Anschlußverbindung aufweisen, so daß mehrere Kontaktpunkte elektrisch mit einem Anschlußkontakt verbunden sind, und die Grundrasterleiterplatten mit ihren Kontaktpunktschmalseitenflächen in der Grundrasterebene zur Ausbildung des Grundrasters angeordnet sind.

## Beschreibung

Die Erfindung betrifft eine Erfindung zum Prüfen von Leiterplatten nach dem Oberbegriff des Anspruchs 1.

Eine derartige Vorrichtung zum Prüfen von Leiterplatten ist aus der EP 0 875 767 A2 bekannt. Diese Prüfvorrichtung weist ein Grundraster auf, auf dem ein Adapter und/oder ein Translator lagert, auf welche eine zu prüfende Leiterplatte aufgelegt werden kann. Der Adapter und/oder Translator stellt einen elektrischen Kontakt von auf der Leiterplatte befindlichen Leiterplattentestpunkten zu Kontaktpunkten des Grundrasters her. Die Kontaktpunkte des Grundrasters sind elektrisch mit Testanschlüssen einer Auswerteelektronik verbunden, so daß jeder zu testende Leiterplattentestpunkt von der Auswerteelektronik angesprochen werden kann.

Bei dieser bekannten Vorrichtung sind mehrere Kontaktpunkte des Grundrasters elektrisch miteinander verbunden und stehen jeweils mit einem einzigen Testanschluß in Verbindung. Hierdurch kann die Anzahl der die Auswerteelektronik darstellenden Elektronikeinheiten gegenüber herkömmlichen Vorrichtungen zum Prüfen von Leiterplatten drastisch vermindert werden, da mit jeder Elektronikeinheit ein Vielfaches der üblich ansteuerbaren Kontaktpunkte des Grundrasters angesteuert werden kann. Sind beispielsweise jeweils Gruppen von zehn Kontaktpunkten des Grundrasters elektrisch miteinander verbunden, so können mit einer Elektronikeinheit 10 mal soviel Kontaktpunkte angesteuert werden, wie es bei herkömmlichen Vorrichtungen zum Prüfen von Leiterplatten der Fall ist.

Die elektrisch miteinander verbundenen Kontaktpunkte einer Gruppe sind über das Grundraster verteilt angeordnet, da nur so sichergestellt werden kann, daß keine Doppelbelegung eines Anschlußkontaktes derart erfolgt, daß zwei Leiterplattentestpunkte elektrisch mit einem gemeinsamen Anschlußkontakt verbunden sind.

Die Kontaktpunkte des Grundrasters sind auf einer mehrlagigen Leiterplatte ausgebildet. Zwischen den einzelnen Lagen befinden sich Leiterbahnen, die Scankanäle, die die Kontaktpunkte elektrisch miteinander verbinden.

Diese bekannte Vorrichtung zum Prüfen von Leiterplatten hat sich bewährt und weist wesentliche Vorteile gegenüber herkömmlichen Prüfvorrichtungen auf, jedoch ist die Herstellung der mehrlagigen Leiterplatte, auf der die Kontaktpunkte des Grundrasters ausgebildet sind, aufwendig, da eine Vielzahl von Scankanäle eingebracht werden müssen und die Scankanäle keinen Fehler aufweisen dürfen, das heißt, daß kein Kurzschluß zu einem anderen Scankanal bestehen darf und daß ein Scankanal nicht unterbrochen sein darf. Die Herstellung ist bei einem großflächigen Grundraster eine äußerst anspruchsvolle technische Aufgabe, weshalb sie kostenintensiv ist und erhebliches Know How voraussetzt.

Es besteht daher ein Bedarf, nach einer solchen Vorrichtung zum Prüfen von Leiterplatten, bei der Kontaktpunkte des Grundrasters elektrisch miteinander verbunden sind und die dennoch einfach und kostengünstig herstellbar ist.

Die DE 37 17 528 A1 beschreibt eine Vorrichtung zum Prüfen von Leiterplatten, die einen Rasteranpassungs-Adapter aufweist. Der Rasteranpassungs-Adapter besteht aus einem Paket von aneinanderliegenden, jedoch gegeneinander isolierten Leiterplatten, die an einer Stirnseite mit Ausgangskontakten und an zwei weiteren, einander gegenüberliegenden Stirnseiten mit Eingangskontakten versehen sind. Die mit den Eingangskontakten versehenen Stirnseiten sind zwei getrennten Prüfkontakt-Rasterfeldern zugewandt. Diese Prüfkontakt-Rasterfelder besitzen einen größeren Rasterabstand als die Ausgangskontakte. Mit diesem Rasteranpassungs-Adapter soll das weite Raster der Prüfkontakt-Rasterfelder auf ein enges Raster, der Leiterplattentestpunkte reduziert werden.

Die EP 0 331 614 A1 betrifft eine Adaptereinrichtung für eine Vorrichtung zum Prüfen von Leiterplatten. Die Adaptereinrichtung ist aus mehreren Segmenten zusammengesetzt, wobei jedes Segment aus zwei Leiterplatten besteht, zwischen welchen Kontaktstifte eingeklemmt werden. Die Kontaktstifte sind zum Kontaktieren mit den Leiterplattentestpunkten vorgesehen und mittels in den Leiterplatten eingebrachten Leiterbahnen und Durchkontaktierungen elektrisch mit Kontaktelementen verbunden, die auf der den Kontaktstiften gegenüberliegenden Seite an den jeweiligen Segmenten vorstehen. Diese Kontaktelemente sind mit größeren Abständen als die Kontaktstifte angeordnet und dienen zur Kontaktierung eines Kontaktfeldes einer Auswerteanordnung.

Die EP 0 263 244 A1 beschreibt ein Leiterplattenprüf gerät mit mehreren Treiberplatten, die jeweils einen Kontaktfeldstecker aufweisen, die in der Vorrichtung derart nebeneinander anliegend angeordnet sind, so dass die aus den Kontaktfeldsteckern hervorragenden Kontaktstifte ein gleichmäßiges Raster ausbilden. Über diesem Raster sind streifenförmige und vertikal stehende Federkontaktfeldkörper angeordnet, wobei diese Federkontaktfeldkörper jeweils mit einer Vielzahl von Bohrungen versehen sind, in welchen Federelemente lagern. Auf diese Federelemente ist jeweils ein Prüfstift derart aufgesetzt, dass er über die Federelemente mit den Kontaktstiften elektrisch verbunden ist. Die Kontaktstifte sind wiederum über Leitungen mit der Treiberplatte elektrisch verbunden.

Die EP 0 145 830 A1 betrifft eine Kontaktfeldanordnung für ein Leiterplattenprüfgerät. Die Kontaktfeldanordnung wird durch eine Anzahl von parallelen nebeneinander angeordneter Treiberkarten ausgebildet, die an einem Ende mit einem Kontaktstecker versehen sind, in dem die Kontaktstifte zum Kontaktieren der Leiterplattentestpunkte angeordnet sind. Diese Kontaktstecker werden derart nebeneinander angeordnet, dass ein gleichmäßiges Raster an Kontaktstiften ausgebildet ist.

Die DE 33 40 179 C1 beschreibt einen Rasteranpassungsadapter, der zum Umsetzen eines Ausgangsrasters mit großem Rasterabstand auf ein Endraster mit kleinem Rasterabstand dient. Hierzu sind zwei Reduktionsebenen vorgesehen, in welchen jeweils vertikal stehende, streifenförmige Leiterplatten dicht gepackt nebeneinander liegend angeordnet sind. Die Leiterplatten sind jeweils mit Leiterbahnen versehen, deren Abstände in Richtung zum Ausgangsraster zunehmen. Hierdurch werden die engen Abstände des Endrasters auf die großen Abstände des Ausgangsrasters abgebildet.

Der Erfindung liegt die Aufgabe zugrunde, die eingangs angegebene Vorrichtung zum Prüfen von Leiterplatten derart weiterzubilden, daß sie einfacher und kostengünstiger hergestellt werden kann und einfach und kostengünstig gewartet werden kann.

Die Aufgabe wird durch eine Vorrichtung mit den Merkmalen des Anspruchs 1 gelöst. Vorteilhafte Ausgestaltungen der Erfindung sind in den Unteransprüchen angegeben.

Die erfindungsgemäße Vorrichtung zum Prüfen von Leiterplatten weist eine Auswerteelektronik und ein Grundraster auf, das in einem regelmäßigen Raster in einer Grundrasterebene angeordnete Kontaktpunkte besitzt, die elektrisch mit der Auswerteelektronik verbunden sind, so daß Leiterplattentestpunkte einer zu prüfenden Leiterplatte, die mittels eines Adapters und/oder eines Translators mit den Kontaktpunkten des Grundrasters in Verbindung bringbar sind, elektrisch abgetastet werden können, wobei mehrere Kontaktpunkte des Grundrasters elektrisch miteinander verbunden sind.

Die erfindungsgemäße Vorrichtung zeichnet sich dadurch aus, daß mehrere Grundrasterleiterplatten vorgesehen sind, die jeweils eine Kontaktpunktschmalseitenfläche aufweisen, an der die Kontaktpunkte angeordnet sind, und die Grundrasterleiterplatten mit Leiterbahnen versehen sind, die jeweils mit mehreren Kontaktpunkten elektrisch verbunden sind und eine zu einem Anschlußkontakt zum Anschließen der Auswerteelektronik führende elektrische Anschlußverbindung aufweisen, so daß mehrere Kontaktpunkte elektrisch mit einem Anschlußkontakt verbunden sind, und die Grundrasterleiterplatten mit ihren Kontaktpunktschmalseitenflächen in der Grundrasterebene zur Ausbildung des Grundrasters angeordnet sind.

Durch die erfindungsgemäße Ausgestaltung der Vorrichtung zum Prüfen von Leiterplatten, wird das Grundraster nicht durch eine einzige Leiterplatte ausgebildet, sondern die Kontaktpunkte des Grundrasters sind an den Kontaktpunktschmalseitenflächen der Grundrasterleiterplatten angeordnet, so daß viele Grundrasterleiterplatten mit ihren Kontaktpunktschmalseitenflächen eine, nicht notwendigerweise zusammenhängende, Fläche bilden, in der das Grundraster ausgebildet ist. Durch das Vorsehen der Grundrasterleiterplatten können die Leiterbahnen, die die Kontaktpunkte miteinander verbinden, auf der gesamten Fläche der Grundrasterleiterplatten verteilt angeordnet werden, wodurch sich deren Herstellung gegenüber der eingangs beschriebenen Ausbildung des Grundrasters auf einer mehrlagigen Leiterplatte, in der die Scankanäle in den einzelnen Lagen als dünne, sehr eng beieinander liegende Leiterdrähte ausgebildet sind, wesentlich vereinfacht. Mit den erfindungsgemäßen Grundrasterleiterplatten können die Leiterbahnen mit wesentlich größerer Breite vorgesehen werden, da der hier zur Verfügung stehende Platz lediglich durch den Rasterabstand des Grundrasters und die Größe der Grundrasterleiterplatten begrenzt ist, die an sich beliebig gewählt werden kann.

Die Grundrasterleiterplatten stehen vorzugsweise senkrecht zur Grundrasterebene. Grundsätzlich ist es jedoch auch möglich, daß sie unter einem bestimmten Winkel geneigt zur Grundrasterebene angeordnet sind, wobei dann die Kontaktpunktschmalseitenflächen entsprechend schiefwinklig zu den Seitenflächen der Grundrasterleiterplatten ausgebildet sind, damit sie eine ebenflächige Fläche bilden, auf welcher ein Adapter und/oder ein Translator aufgelegt werden kann.

Vorzugsweise sind die Grundrasterleiterplatten aus mehreren Lagen ausgebildet, wobei die Lagen voneinander durch eine elektrisch isolierende Zwischenlage getrennt sind, und die Kontaktpunkte jeweils mit einer quer zu den Kontaktpunktschmalseitenflächen verlaufenden Kontaktpunktleiterbahnen elektrisch verbunden sind. An einer Oberfläche einer Lage, auf der keine Kontaktpunktleiterbahnen angeordnet sind, sind mehrere Busleiterbahnen vorgesehen, die quer zu den Kontaktpunktleiterbahnen verlaufen, wobei jede Kontaktpunktleiterbahn mit einer der Busleiterbahnen mittels einer Durchkontaktierung elektrisch verbunden ist. Die Vielzahl von Kontaktpunkten werden somit mit den Kontaktpunktleiterbahnen auf eine relativ geringe Anzahl von Busleiterbahnen geführt. Diese Busleiterbahnen stellen die elektrische Verbindung zwischen mehreren der Kontaktpunktleiterbahnen dar. Die Anschlußkontakte für die Auswerteelektronik können sowohl an den Busleiterbahnen oder an einer entsprechenden Anzahl von Kontaktpunktleiterbahnen vorgesehen werden. Die Anordnung der miteinander elektrisch verbundenen Kontaktpunkte des Grundrasters wird durch die Anordnung bzw. das Muster der Durchkontaktierungen auf den Grundrasterleiterplatten festgelegt, da die Anordnung der Durchkontaktierung bestimmt, welche Busleiterbahn mit welcher Kontaktpunktleiterbahn und folglich mit welchem Kontaktpunkt des Grundrasters elektrisch verbunden ist. Das Einbringen derartiger Durchkontaktierungen ist technisch einfach, wodurch auf einfache Art und Weise die Gruppierungen von elektrisch miteinander verbundenen Kontaktpunkten festgelegt werden.

Nach einer bevorzugten Ausführungsform werden Anschlußkontakte unterschiedlicher Grundrasterleiterplatten mittels einer Verknüpfungsplatte elektrisch miteinander verbunden. An die Verknüpfungsplatte sind Elektronikeinheiten der Auswerteelektronik angeschlossen und über die Leiterbahnen der Verknüpfungsplatte elektrisch mit den Anschlußkontakten der Grundrasterleiterplatten verbunden.

Nach einer weiteren Ausführungsform können die Busleiterbahnen mit Buskontaktpunkten versehen sein, wobei mehrere Buskontaktpunkte elektrisch miteinander verbunden werden können, so daß Kontaktpunkte unterschiedlicher Grundrasterleiterplatten elektrisch miteinander verbunden sind. Zum elektrischen Verbinden mehrerer Busleiterbahnen wird vorzugsweise eine Verknüpfungsplatte vorgesehen, die auf die Buskontaktpunkte aufgesetzt werden kann.

Die Erfindung wird nachfolgend anhand eines in der Zeichnung dargestellten Ausführungsbeispieles näher beschrieben. In der Zeichnung zeigen schematisch:
- Fig. 1: ein Paket von Grundrasterleiterplatten, an dessen Oberseite das Grundraster ausgebildet ist,
- Fig. 2a und 2b: jeweils eine Grundrasterleiterplatte mit ihren Leiterbahnen, und
- Fig. 3: schematisch vereinfacht einen Ausschnitt des Grundrasters in der Draufsicht.

Die erfindungsgemäße Vorrichtung zum Prüfen von Leiterplatten weist ein Grundraster 1 auf, das aus einer Vielzahl, in einem regelmäßigem Raster in einer Grundrasterebene angeordneter Kontaktpunkte 2 ausgebildet ist.

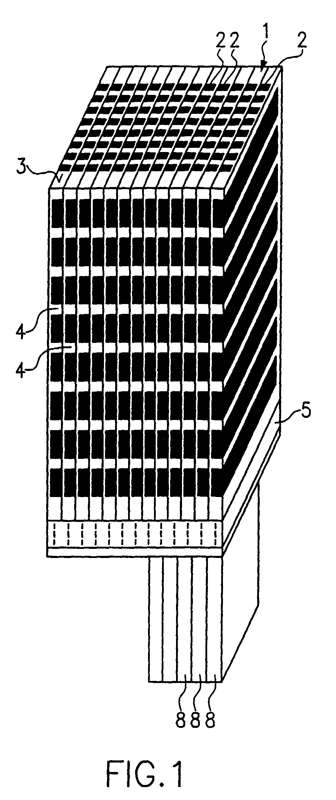

Die Kontaktpunkte 2 sind an Schmalseitenflächen, den Kontaktpunktschmalseitenflächen 3, von Grundrasterleiterplatten 4 angeordnet. Die Grundrasterleiterplatten sind ohne Abstand mit ihren Seitenflächen aneinander liegend angeordnet, so daß sie ein quaderförmiges Paket bilden. An der Oberseite dieses Paketes ist bei dem in Fig. 1 dargestellten Ausführungsbeispiel das Grundraster 1 vorgesehen. Selbstverständlich ist es auch möglich, das Paket mit dem Grundraster 1 nach unten weisend anzuordnen. Eine solche Anordnung wird bspw. bei doppelseitig prüfenden Prüfvorrichtungen verwendet, bei welchen zwei Grundraster einander gegenüberliegend angeordnet sind.

Die Grundrasterleiterplatten weisen Leiterbahnen auf, mit denen jeweils Gruppen von Kontaktpunkten 2 elektrisch miteinander verbunden sind. Es besteht somit eine elektrische Verknüpfung der Kontaktpunkte 2 einer Gruppe. Die Leiterbahnen werden unten näher erläutert. An den den Kontaktpunktschmalseitenflächen 3 gegenüberliegenden Schmalseitenflächen der Grundrasterleiterplatten 4 sind Anschlußkontakte ausgebildet, die wiederum ein Kontaktpunktraster darstellen, das aber wesentlich größere Rasterabstände als das Grundraster besitzt, da jeweils einem Anschlußkontakt mehrere Kontaktpunkte 2 des Grundrasters zugeordnet sind.

Bei dem in Fig. 1 dargestellten Ausführungsbeispiel sind die Anschlußkontakte an der Unterseite des Pakets von Grundrasterleiterplatten 4 angeordnet. Die Grundrasterleiterplatten 4 stehen auf einer Vollrasterkassette 5, in der in dem Raster der Anschlußkontakte Federkontaktstifte derart vorgesehen sind, daß jeder Anschlußkontakt von einem Federkontaktstift 6 berührt wird. Die Federkontaktstifte 6 sind in der Vollrasterkassette 5 zueinander parallel angeordnet. Sie stehen an der Unterseite der Vollrasterkassette 5 etwas vor, so daß sie Kontaktstellen einer Verknüpfungsplatte 7 kontaktieren können.

Die Verknüpfungsplatte 7 ist eine Leiterplatte, mit Kontaktstellen, die mittels Leiterbahnen elektrisch miteinander verbunden sind. Die Kontaktstellen stehen mit den Federkontaktstiften 6 derart in Kontakt, daß Gruppen von Anschlußkontakten unterschiedlicher Grundrasterleiterplatten gebildet werden, die elektrisch miteinander verknüpft sind. Der Aufbau der Verknüpfungsplatte ist ähnlich zu dem der eingangs erwähnten Leiterplatte zu Bildung eines Grundrasters gemäß der EP 0 875 767 A2. Da das Raster der Anschlußkontakte wesentlich gröber als ein Grundraster ist, ist die Anzahl der Kontaktstellen und der Leiterbahnen entsprechend geringer, weshalb eine derartige Verknüpfungsplatte einfach herstellbar ist.

Auf der von der Vollrasterkassette 5 abgewandten Seite der Verknüpfungsplatte 7 enden die Leiterbahnen der Verknüpfungsplatte 7 an weiteren Kontaktstellen, an welchen Elektronikeinheiten 8 der Auswerteelektronik angeschlossen sind.

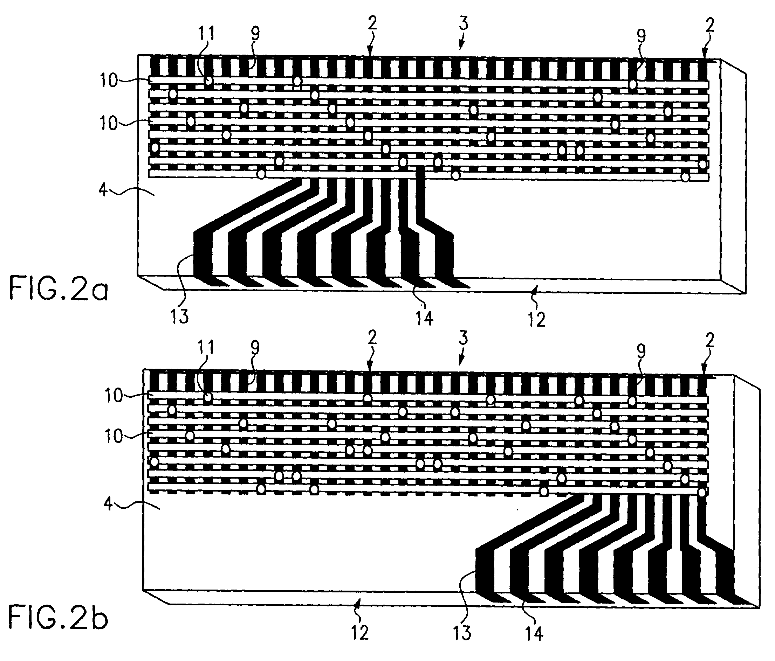

Die Struktur der Leiterbahnen der Grundrasterleiterplatten 4 wird nachfolgend näher anhand von Fig. 2a und 2b erläutert. Jeder Kontaktpunkt 2 des Grundrasters 1 ist mit einer Kontaktpunktleiterbahn 9 elektrisch verbunden, die sich quer zur Kontaktpunktschmalseitenfläche 3 auf der Grundrasterleiterplatte 4 erstreckt. Diese Kontaktpunktleiterbahnen 9 sind auf einer Seitenfläche der Grundrasterleiterplatte 4 ausgebildet. Auf der gegenüberliegenden Seitenfläche der Grundrasterleiterplatten 4 sind Busleiterbahnen 10 ausgebildet, die quer zu den Kontaktpunktleiterbahnen verlaufen. Jeweils eine Kontaktpunktleiterbahn 9 ist mit einer Busleiterbahn 10 mittels einer sich durch die Grundrasterleiterplatte 4 hindurch erstreckende Durchkontaktierung 11 elektrisch verbunden. Eine solche Durchkontaktierung ist eine mit einem leitenden Material beschichtete Bohrung. Die Durchkontaktierungen sind an Kreuzungspunkten von jeweils einer der Kontaktpunktleiterbahnen 9 und jeweils einer der Busleiterbahnen 10 angeordnet, wobei die Durchkontaktierungen die sich kreuzenden Leiterbahnen 9, 10 elektrisch miteinander verbinden.

Mit einer Busleiterbahn 10 einer Grundrasterleiterplatte 4 sind mehrere Kontaktpunktleiterbahnen 9 und damit mehrere Kontaktpunkte 2 elektrisch verbunden. Durch das Muster, mit welchem die Durchkontaktierungen 11 in die Grundrasterleiterplatten gebohrt werden, wird die elektrische Verbindung bzw. Verknüpfung der Kontaktpunkte 2 mittels der Busleiterbahnen 10 festgelegt.

Einige der Kontaktpunktleiterbahnen 9 werden mit einer Anschlußverbindung 13 zu einer der der Kontaktpunktschmalseitenfläche 3 gegenüberliegenden Schmalseitenfläche, der Anschlußkontaktschmalseitenfläche 12, der Grundrasterleiterplatten 4 geführt. An der Anschlußkontaktschmalseitenfläche 12 sind die Anschlußkontakte 14 ausgebildet. Die Anzahl der Anschlußverbindungen 13 entspricht der Anzahl der Busleiterbahnen 10 bzw. der Anzahl der elektrisch miteinander verbundenen Gruppen von Kontaktpunkten 2.

Zweckmäßigerweise sind diese Leiterplatten mit jeweils einer Reihe Kontaktpunkte 2, einem Satz Kontaktpunktleiterbahnen 9 und Busleiterbahnen 10 auf einem dünnlagigen Leiterplattenmaterial ausgebildet, wobei mehrere dieser Lagen zu einer Grundrasterleiterplatte verpreßt und verbunden werden. Hierbei sind zwischen den einzelnen Lagen jeweils Isolierschichten angeordnet, die z.B. aus Prepreg-Lagen bestehen. Eine derartige mehrlagige Grundrasterleiterplatte weist für jede Lage eine Reihe von Kontaktpunkten 2 auf. Die Anschlußverbindungen 13 benachbarter Lagen sind vorzugsweise in Längsrichtung der Busleiterbahnen 10 versetzt angeordnet, da dann die Anschlußkontakte 14 sich über mehrere Lagen erstrecken können und Anschlußkontakte 14 mit entsprechend großen Flächen vorgesehen werden können, die in einem regelmäßigen Raster angeordnet sind.

Die Kontaktpunkte 2 des Grundrasters 1 sind somit wesentlich dichter angeordnet als die Anschlußkontakte 14. Mit den erfindungsgemäßen Grundrasterleiterplatten 4 wird somit auch eine Transformierung von dem groben Raster der Anschlußkontakte 14 auf das feine Grundraster 1 bewerkstelligt.

Durch die Verknüpfung mittels der Busleiterbahnen 10 und der Verknüpfungsplatte 7 können beispielsweise Gruppen mit jeweils 60 Kontaktpunkten 2 des Grundrasters 1 elektrisch miteinander verbunden sein. Bei einem Grundraster mit 491.520 Kontaktpunkten 2 ergeben sich auf der mit der Elektronikeinheiten 8 in Verbindung stehenden Ausgangsseite der Verknüpfungsplatte 7 lediglich 8.192 Testpunkte. Dies zeigt, daß mit wenig Elektronikeinheiten eine große Anzahl von Kontaktpunkten 2 angesprochen werden kann.

Bei diesem Ausführungsbeispiel mit 491.520 Kontaktpunkten sind diese beispielsweise mit einem Rasterabstand von 0,635 mm (25 mil) angeordnet. Die einzelnen Lagen der Grundrasterleiterplatte 4 weisen den gleichen Abstand auf, das heißt, daß deren Dicke zusammen mit einer daran angrenzenden Isolationsschicht 0,635 mm beträgt.

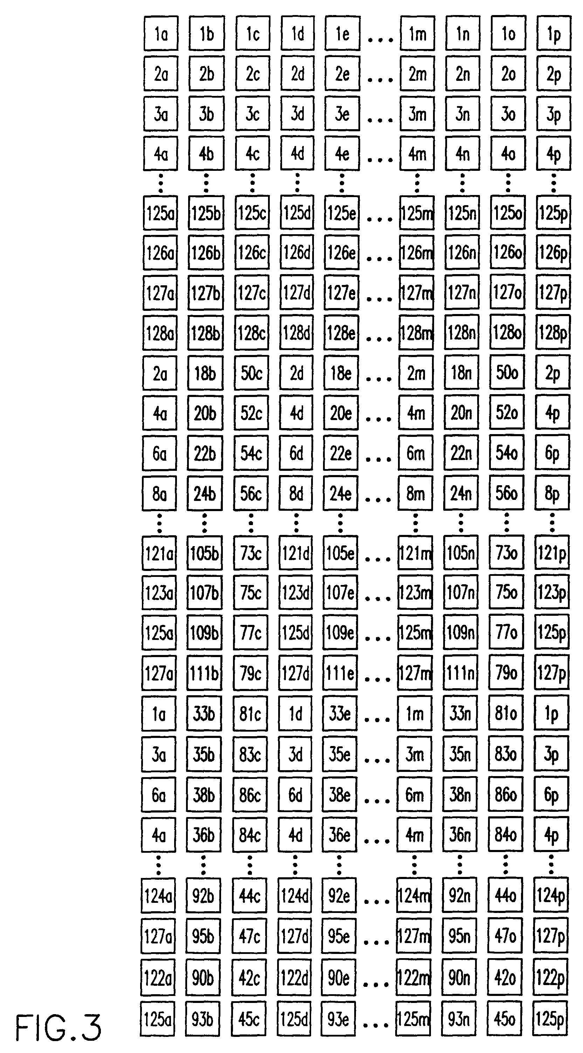

Ein Ausschnitt eines derartigen Grundrasters 1 ist schematisch in Fig. 3 dargestellt. Dieser Ausschnitt zeigt schematisch einen Block von Grundrasterleiterplatten 4, bei welchen es keine Verknüpfung zwischen Kontaktstellen unterschiedlicher Grundrasterleiterplatten gibt. Es gibt somit keine Verknüpfungen zwischen Kontaktstellen unterschiedlicher Grundrasterleiterplatten mittels der Verknüpfungsplatte innerhalb eines Blockes. Derartige Verknüpfungen sind lediglich zwischen den Blöcken vorgesehen.

In den Grundrasterleiterplatten a bis p sind jeweils 128 Gruppen von miteinander verknüpften Kontaktpunkten durch Eintragung der jeweiligen Gruppennummer an den Kontaktpunkten dargestellt. Nach dieser bevorzugten Anordnung sind in einem Block benachbarte Kontaktpunkte jeweils unterschiedlichen Gruppen zugeordnet, das heißt, daß zwei benachbarte Kontaktpunkte niemals den gleichen Gruppen zugeordnet sind, wie zwei andere benachbarte Kontaktpunkte. Hierdurch wird sichergestellt, daß, falls beim Überprüfen (Debuggen) des erfindungsgemäßen Grundrasters selbst ein Kurzschluß zwischen zwei benachbarten Kontaktpunkten festgestellt wird, die zwei benachbarten Kontaktpunkte des Grundrasters eindeutig lokalisiert werden können. Hierdurch kann das erfindungsgemäße Grundraster blockweise einfach überprüft werden.

Wie man Fig. 3 entnehmen kann, besitzen die Grundrasterleiterplatten a, d, m, p bzw. b, e, n bzw. c, o jeweils die gleiche Verbindungsstruktur, d.h., das gleiche Muster an Durchkontaktierungen zum Verbinden Kontaktpunktleiterbahnen mit den Busleiterbahnen. Somit lassen sich mit lediglich drei unterschiedlichen Verbindungsstrukturen Blöcke realisieren, in welchen benachbarte Kontaktpunkte jeweils unterschiedlichen Gruppen von verknüpften Kontaktpunkten zugeordnet sind.

Die Oberflächen der Grundrasterleiterplatten 4 sind mit einer Isolationsschicht versehen, die beispielsweise ein Isolationslack oder eine weitere Prepreg-Lage ist.

Das oben beschriebene Ausführungsbeispiel zeigt, daß die Busleiterbahnen in an sich beliebiger Breite vorgesehen werden können und die Kontaktpunktleiterbahnen auf der Oberfläche der einzelnen Lagen mit einer dem Rasterabstand des Grundrasters entsprechenden Breite aufgebracht werden können. Diese Leiterbahnen lassen sich deshalb einfach mittels einer Foto-/Ätztechnik herstellen, wodurch ein wesentlicher Vorteil gegenüber der eingangs beschriebenen Vorrichtung geschaffen wird, bei der die korrespondierenden Leiterbahnen sehr eng beieinander liegend in einer einzigen, das gesamte Grundraster abdeckenden Leiterplatte angeordnet sind. Die einzelnen Lagen der erfindungsgemäßen Grundrasterleiterplatten 4 werden bei der Herstellung mit den gleichen Sätzen von Filmen zur Ausbildung der Leiterbahnen belichtet, da sie sich die einzelnen Lagen lediglich in den Anschlußverbindungen und im Bohrmuster unterscheiden. Die übrigen Leiterbahnen sind für alle Lagen identisch. Es genügt deshalb, daß für jeden Lagentyp mit einer bestimmten Anordnung der Anschlußverbindungen ein Satz Filme vorgesehen wird. Diese spezielle Ausführungsform ermöglicht somit eine sehr günstige Herstellung. Die Anzahl der Busleitungen ist lediglich durch die Höhe der Grundrasterleiterplatten begrenzt, die jedoch frei wählbar ist. Es hat sich gezeigt, daß eine zweckmäßige Anzahl von Busleiterbahnen, die im Bereich von 30 bis 60 liegt, eine Leiterplattenhöhe, der senkrecht stehenden Grundrasterleiterplatten bedient, die wesentlich geringer als deren Länge ist. Die Grundrasterleiterplatten weisen somit eine streifenförmige Form auf.

Bei herkömmlichen Grundrastern wird der Kontakt zwischen den Kontaktpunkten und den entsprechenden elektrischen Verbindungen mittels einer Durchkontaktierung ausgebildet, so daß in den flächenhaft ausgebildeten Kontaktpunkten kleine Löcher eingebracht sind. Diese Löcher können den Kontakt mit den entsprechenden Kontaktstiften eines auf den Grundraster angeordneten Adapters beeinträchtigen. Da bei der Erfindung die Kontaktpunkte 2 mit den Kontaktpunktleiterbahnen 9 in elektrischer Verbindung stehen, die auf der Oberfläche der Lagen bzw. der Grundrasterleiterplatte angeordnet sind, wobei die Kontaktpunktleiterbahnen 9 und die Kontaktpunkte 2 als eine durchgehende Leiterbahn ausgebildet sind, gibt es keine Löcher im Bereich der Kontaktpunkte. Dies trägt zur Vermeidung von Fehlkontakten bei.

Da die Kontaktpunkte 2 auf den Kontaktpunktschmalseitenflächen 3 angeordnet sind, und diese aus dem Grundraster 1 einfach entfernt werden können, können auch die in der Regel als Goldschichten ausgebildeten Kontaktpunkte bei einer Zerstörung von Neuem aufgebracht werden. Die erfindungsgemäße Ausgestaltung mit Grundrasterleiterplatten erlaubt somit eine einfache Wartung des Grundrasters.

Die Erfindung ist oben anhand eines Ausführungsbeispiels näher erläutert worden. Im Rahmen der Erfindung sind jedoch Abwandlungen möglich. So ist es z.B. nicht notwendig, daß eine Verknüpfungsplatte vorgesehen ist, die Leiterbahnen unterschiedlicher Grundrasterleiterplatten bzw. unterschiedlicher Lagen der Grundrasterleiterplatten elektrisch miteinander verbindet. Wird keine Verknüpfungsplatte vorgesehen, so sind alle Anschlußkontakte der Grundrasterleiterplatten mit jeweils einem entsprechenden Anschlußkontakt der Elektronikeinheiten elektrisch zu verbinden. Im Rahmen der Erfindung ist es auch möglich, die Busleitungen bis zu einer zur Kontaktpunktschmalseitenfläche quer verlaufenden Schmalseitenfläche der Grundrasterleiterplatten zu führen und mit entsprechenden Buskontaktpunkten zu versehen, an welche eine von der Auswerteelektronik unabhängige Verknüpfungsplatte zum elektrischen Verbinden vorbestimmter Busleiterbahnen angesetzt werden kann.

### Bezugszeichenliste

- 1: Grundraster
- 2: Kontaktpunkte
- 3: Kontaktpunktschmalseitenfläche
- 4: Grundrasterleiterplatten
- 5: Vollrasterkassette
- 6: Federkontaktstift
- 7: Verknüpfungsplatte
- 8: Elektronikeinheiten
- 9: Kontaktpunktleiterbahn
- 10: Busleiterbahn
- 11: Durchkontaktierung
- 12: Anschlußkontaktschmalseitenfläche
- 13: Anschlußverbindung
- 14: Anschlußkontakte

## Patentansprüche

1. Vorrichtung zum Prüfen von Leiterplatten, mit
einer Auswerteelektronik,
einem Grundraster (1), das in einem regelmäßigen Raster in einer Grundrasterebene angeordnete Kontaktpunkte (2) aufweist, die elektrisch mit der Auswerteelektronik (8) verbunden sind, so daß Leiterplattentestpunkte einer zu prüfenden Leiterplatte, die mittels eines Adapters und/oder eines Translators mit den Kontaktpunkten (2) des Grundrasters (1) in Verbindung bringbar sind, elektrisch abgetastet werden können, wobei mehrere Kontaktpunkte (2) des Grundrasters (1) elektrisch miteinander verbunden sind, wobei
mehrere Grundrasterleiterplatten (4), die jeweils eine Kontaktpunktschmalseitenfläche (3) aufweisen, an der die Kontaktpunkte (2) angeordnet sind,
und mit Leiterbahnen versehen sind, die jeweils mit mehreren Kontaktpunkten (2) elektrisch verbunden sind und eine zu einem Anschlußkontakt (14) zum Anschließen der Auswerteelektronik (8) führende elektrische Anschlußverbindung (13) aufweisen, so daß mehrere Kontaktpunkte (2) elektrisch mit einem Anschlußkontakt (14) verbunden sind, und
die Grundrasterleiterplatten (4) mit ihren Kontaktpunktschmalseitenflächen (3) in der Grundrasterebene zur Ausbildung des Grundrasters (1) angeordnet sind.

2. Vorrichtung nach Anspruch 1,
wobei die Grundrasterleiterplatten (4) mit ihren Flächen angrenzend aneinanderliegend angeordnet sind.

3. Vorrichtung nach Anspruch 1 oder 2, wobei die Grundrasterleiterplatten (4) jeweils aus mehreren Lagen ausgebildet sind, wobei die Lagen voneinander durch eine elektrisch isolierende Zwischenlage getrennt sind, und
die Kontaktpunkte jeweils mit einer quer zu den Kontaktpunktschmalseitenfläche verlaufenden Kontaktpunktleiterbahn (9) elektrisch verbunden sind, und
an einer Oberfläche einer Lage mehrere Busleiterbahnen (10) angeordnet sind, wobei jede Kontaktpunktleiterbahn (9) mit einer der Busleiterbahnen (10) mittels einer Durchkontaktierung (11) elektrisch verbunden ist.

4. Vorrichtung nach Anspruch 3,
wobei die Dicke einer Lage und einer dazugehörigen Zwischenlage dem Abstand benachbarter Kontaktpunkte (2) des Grundrasters (1) entspricht.

5. Vorrichtung nach Anspruch 3 oder 4,
wobei die Seitenflächen der Grundrasterleiterplatten mit einer Isolierschicht versehen sind, die z.B. ein Isolierlack oder eine Prepreg-Lage ist.

6. Vorrichtung nach einem der Ansprüche 3 bis 5,
wobei mehrere Kontaktpunktleiterbahnen (9) elektrisch mit einer gemeinsamen Busleiterbahn (10) verbunden sind, und daß lediglich eine einzige dieser Kontaktpunktleiterbahnen (9) mit einer zum Anschließen der Auswerteelektronik (8) führenden Anschlußverbindung (13) versehen ist.

7. Vorrichtung nach einem der Ansprüche 1 bis 6,
wobei die Anschlußverbindung (13) jeweils an einem Anschlußkontakt (14) enden, wobei der Abstand benachbarter Anschlußkontakte (14) größer als der Abstand benachbarter Kontaktpunkte (2) des Grundrasters (1) ist.

8. Vorrichtung nach Anspruch 7,
wobei die Anschlußkontakte (14) an den Grundrasterleiterplatten (4) an den den Kontaktpunktschmalseitenflächen (3) gegenüberliegenden Schmalseitenflächen (12) angeordnet sind.

9. Vorrichtung nach einem der Ansprüche 3 bis 8,
wobei zumindest zwei der Busleiterbahnen (10) elektrisch miteinander verbunden sind.

10. Vorrichtung nach Anspruch 9,
wobei Gruppen der Anschlußkontakte (12) mittels einer Verknüpfungsplatte elektrisch miteinander verbunden sind.

11. Vorrichtung nach Anspruch 9,
wobei die Busleiterbahnen bis zu einer quer zur Kontaktpunktschmalseitenfläche (3) verlaufenden Schmalseitenfläche der Grundrasterleiterplatten (4) geführt sind, an welchen Buskontaktpunkte ausgebildet sind, über welche vorbestimmte Busleiterbahnen (10) mittels einer Verknüpfungsplatte elektrisch miteinander verbunden werden können.

12. Vorrichtung nach einem der Ansprüche 1 bis 11,
wobei das Grundraster (1) in Blöcke unterteilt ist, in welchen benachbarte Kontaktpunkte (2) jeweils unterschiedlichen Gruppen von elektrisch miteinander verbundenen Kontaktpunkten zugeordnet sind.
